(19) Europäisches Patentamt

European Patent Office

Office européen des brevets

(11) **EP 1 039 347 B1**

(12) **EUROPEAN PATENT SPECIFICATION**

(45) Date of publication and mention
of the grant of the patent:
**17.12.2003 Bulletin 2003/51**

(51) Int Cl.[7]: **G03F 7/09**

(21) Application number: **00104736.4**

(22) Date of filing: **04.03.2000**

(54) **Antireflective coating for improving cd control**

Reflexionsvermindernde Schicht zur Kontrolle von kritischen Dimensionen

Couche antiréfléchissante pour un meilleur contrôle des dimensions critiques

(84) Designated Contracting States:
**DE FR GB IE IT NL**

(30) Priority: **25.03.1999 US 276026**

(43) Date of publication of application:
**27.09.2000 Bulletin 2000/39**

(73) Proprietor: **Infineon Technologies North America Corp.**
**San Jose, CA 95112-6000 (US)**

(72) Inventors:
 • **Toebben, Dirk**
 **07465 Langebrueck (DE)**
 • **Lee, Yong Gill**
 **Fishkill, New York 12524 (US)**
 • **Lu, Zhijian**
 **Poughkeepsie, New York 12603 (US)**

(74) Representative: **Patentanwälte**
**Westphal, Mussgnug & Partner**
**Am Riettor 5**
**78048 Villingen-Schwenningen (DE)**

(56) References cited:
 • **CIRELLI R A ET AL: "A MULTILAYER INORGANIC ANTIREFLECTIVE SYSTEM FOR USE IN 248 NM DEEP ULTRAVIOLET LITHOGRAPHY" JOURNAL OF VACUUM SCIENCE AND TECHNOLOGY: PART B,US,AMERICAN INSTITUTE OF PHYSICS. NEW YORK, vol. 14, no. 6, 1 November 1996 (1996-11-01), pages 4229-4233, XP000721153 ISSN: 0734-211X**
 • **T. TANAKA ET AL.: "A novel antireflective method with gradient photoabsorption for optical lithography" PROCEEDINGS OF SPIE - INT. SOC. OPT. ENG., vol. 2726, 15 March 1996 (1996-03-15), pages 573-582, XP000905420 USA**

## Description

This application is a continuation-in-part of USSN 09/221,092 titled "IMPROVED CD CONTROL":

Field of the Invention

The invention relates generally to a method for reducing reflectivity in a resist during the fabrication of integrated circuits and more particularly to the improving CD control during patterning.

Such methods are known for example from CIRELLI R. A. et al.: "A MULTILAYER INORGANIC ANTIREFLECTIVE SYSTEM FOR USE IN 248 NM DEEP ULTRAVIOLET LITHOGRAPHY", Journal of Vacuum Science and Technology, part B, US, American Institute of Physics, New York, vol. 14, No. 6, 1 Nov. 1996 (1996-11-01). pages 4229-4233, XP000721153 ISSN: 0734-211X and T. TANAKA et al.: "A novel antireflective method with gradient photoabsorption for optical lithography", PROCEEDINGS OD SPIE — INT. SOC. OPT. ENG., vol 2726, 15 March 1996 (1996-03-15), pages 573-582, XP000905420 USA.

Background of the Invention

In formation of semiconductor integrated circuits (ICs), features are formed on a substrate. These features, for example, correspond to devices such as transistors, capacitors, and resistors. These devices are then interconnected to achieve a desired electrical function.

To form the devices, layers are repeatedly deposited on the substrate and patterned as desired. Lithographic techniques are used to pattern the device layer or layers. Such techniques use an exposure source to project a light image from a mask onto a photoresist (resist) layer formed on the surface of the substrate. The light illuminates the resist layer, exposing it with the desired pattern. Depending on whether a positive or negative tone resist is used, the exposed or unexposed portions of the resist layer are removed. The portions not protected by the resist are then, for example, etched to form the features in the substrate.

The dimensions of the features depend on the resolution capability of the lithographic systems. The minimum feature size (F) achieved by a given generation of lithographic systems is referred to as the lithographic groundrule (GR). Critical dimension (CD) is defined as the minimum feature size that must be controlled. This includes, for example, linewidths, spacings, and contact widths.

Due to the variations of light or reflectance into the resist layer, variations in CD occur. Controlling the variations in CD (CD control) becomes a critical issue, particularly with aggressively shrinking GRs, (e.g., 0.25 microns or below). CD control is facilitated by the use of an antireflective coating (ARC) beneath the resist to reduce reflectance variations into the resist caused by underlying layers.

The ARC can be used in one of two operational modes to prevent reflectance variations into the resist. The first mode is absorption and the second mode is destructive interference.

In the absorption mode, the ARC absorbs light passing through it. In this manner, scattering light is prevented from exposing the resist undesirably. The ARC should have a suitable extinction coefficient (k) and thickness to absorb the light completely. The k and thickness needed to absorb the light completely vary depending on the wavelength of the exposure source. A higher k requires a thinner ARC layer to absorb completely a given amount of light at a given wavelength. Conversely, a lower k would require a thicker ARC layer to absorb completely the given amount of light at the given wavelength. For example, a k of about 0.5 is requires an ARC thickness of about 1000 Å to absorb light at 248 nanometers (nm).

In the destructive interference mode, the reflectance caused by the interface at the bottom surface of the ARC is shifted out of phase with respect to the phase of the reflectance caused by the interface at the top surface of the ARC. By shifting the reflectances appropriately out of phase with respect to each other, they are cancelled out (destructive cancellation).

Conventionally, various organic and inorganic ARCs are used. Organic ARCs include, for example, compounds presently marketed as AR2 and AR3 by Shipley Company. Inorganic ARCs include, for example, silicon nitride, silicon oxynitride, hydrogenated silicon oxynitride, titanium nitride, amorphous silicon, silicon carbide, and amorphous carbon.

Organic ARCs are usually deposited by a spin-on process. Organic ARCs have a relatively fixed refractive index. Different organic ARCs may have different refractive indices. To reduce reflectance at the ARC/resist interface, it is desirable to match the refractive index of the organic ARC with that of the resist. Since organic ARCs have a relatively fixed refractive index, they are usually used only in the absorption mode.

Typically the film stack beneath the ARC have significant thickness variations due to processing such as, for example, film deposition or chemical mechanical polish (CMP). To suppress the effects caused by the thickness variations, a thicker organic ARC is required. The use of a thicker organic ARC in turn requires a thicker resist to sufficiently serve as an etch mask during the ARC open process. The thicker resist leads to a degradation in the depth-of-focus, particularly at smaller GRs (e.g., 0.25 μm or less), resulting in a narrowing of the process window. This has made the use of organic ARCs less attractive for processes at GRs of, for example, 0.25 μm or less.

Inorganic ARCs, on the other hand, have become more popular since they don't have any of the disadvantages associated with organic ARCs. Additionally, inorganic ARCs possess certain advantages such as tunable properties, low defect levels, good conformality, high etch selectivity to resist, and small swing ratio.

Inorganic ARCs, although can be used in either mode, are usually used in the destructive interference mode at the smaller GRs. This is because inorganic ARCs having a sufficiently high k to operate in the absorption mode have a refractive index that does not match the refractive index of the resist. At the smaller GRs, standing waves created by the mismatch in the refractive indices become more pronounced, undesirably resulting in pattern degradation.

In order to produce destructive cancellation when operating in the destructive interference mode, the inorganic ARC needs to be formed on opaque materials or on very uniform transparent materials. In the case where a transparent material such as silicate glass is underneath the inorganic ARC, the thickness variations of the transparent material creates non-uniformities in the intensities of the reflectances. This makes it difficult to take advantage of the destructive interference effect.

The limitations imposed by the destructive interference mode create some difficulties in providing inorganic ARC process with good CD control since the layers below are usually composed of transparent materials, such as silicate glass, that have large thickness variations. Additionally, inorganic ARCs can, in some cases, contaminate the resist (resist poisoning) above. A cap layer such as silicon oxide ($SiO_2$) may be required to avoid resist poisoning. The mismatch in refractive indices between the resist and the cap layer creates standing wave effects in the resist, adversely impacting CD control.

From the foregoing discussion, it is desirable to provide an ARC layer that results in improved CD control.

## Description of the Drawings

Fig. 1 shows an illustrative embodiment of the invention;
Figs. 2a-b show the profile of the refractive index and extinction coefficient, respectively, of the inorganic ARC in accordance with one of the invention;
Fig. 3 shows a profile of the refractive index of the inorganic ARC in accordance with another embodiment of the invention; and
Fig. 4 shows an embodiment of the invention.

## Summary of the Invention

The invention relates to improved CD control in lithography. In accordance with the invention, improved CD control is achieved by using an inorganic ARC having first and second sections. The first section operates in the absorption mode and the second section reduces the difference in the refractive indices of the first section and the photoresist, thereby reducing reflectivity in the resist to improve CD control.

The second section of the inorganic ARC layer comprises a graded refractive index to reduce the difference between the refractive indices between the first section and the resist. At the lower surface of the second section, the refractive index is equal to about the refractive index of the first ARC layer. The refractive index, as it approaches the upper surface of the second inorganic ARC, gradually decreases to equal to about the refractive index of the resist. Providing a graded refractive index reduces the reflectivity in the resist in order to achieve good CD control.

## Description of the Invention

The invention relates to semiconductor processing. In particular, the invention relates to improved CD control, thereby producing a wider lithographic process window. In accordance with the invention, improved CD control is achieved by providing an inorganic ARC that combines absorption and destructive interference properties together.

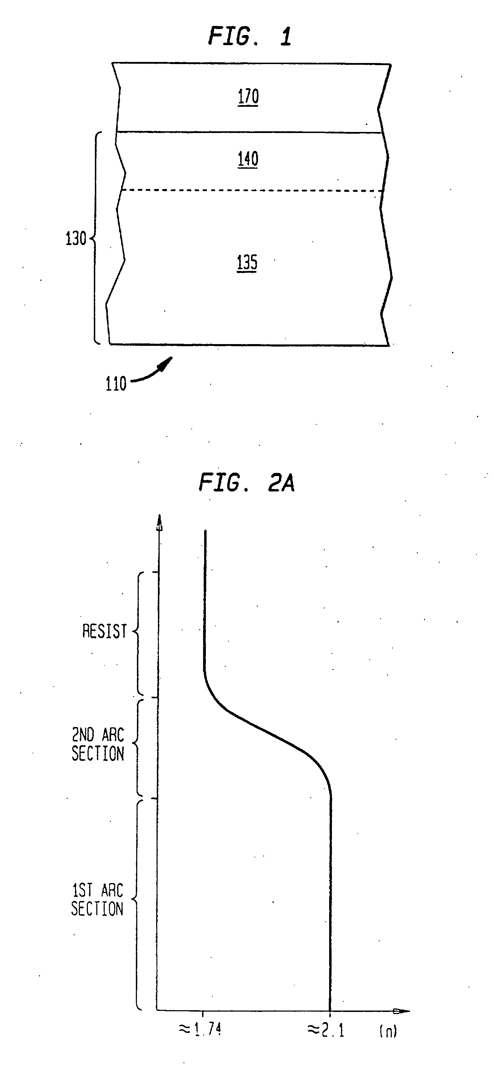

Fig. 1 shows an ARC layer in accordance with one embodiment of the present invention. Illustratively, an ARC layer 130 is provided between the surface of a semiconductor substrate 110 and a resist layer 170. The resist layer comprises, for example, any conventional resist used in lithography. Such resist can either be positive or negative tone resist.

The semiconductor substrate comprises, for example, a silicon wafer. Other types of substrates such as those comprising gallium arsenide, germanium, silicon-on-insulator, or other semiconductor or non-semiconductor materials are also useful. The substrate can be at various stages of the process flow. For example, the substrate can be at the beginning of the process flow or partially processed to include features (not shown). The features are used to form, for example, integrated circuits (ICs) such as dynamic random access memories (DRAMs) or other types of ICs or electromechanical or mechanical devices. For purposes of discussion, the term "substrate" is used to refer to a substrate in general, which can be at any stage in the process flow.

The inorganic ARC layer 130 is formed above the substrate. The inorganic ARC layer comprises, for example, a dielectric ARC (DARC), metallic ARC, or other inorganic antireflective materials. In one embodiment, the inorganic ARC comprises DARC such as silicon nitride ($Si_xN_y$), silicon oxynitride, ($SiN_xO_y$), hydrogenated silicon oxynitride or other types of dielectric antireflective materials. In a preferred embodiment, the DARC comprises silicon oxynitride. The inorganic ARC layer is deposited using conventional techniques such as, for example, chemical vapor deposition (CVD).

The resist is formed over the ARC layer. Any conventional resist material can be used. Typical resist materials comprise an n value of, for example, 1.74. The resist is formed by conventional techniques. The thickness of the resist is sufficient to serve as an etch mask for the ARC open process. Typically, the thickness of the resist layer is about 0.2 - 10 μm.

In accordance with one embodiment of the invention, the inorganic ARC layer comprises first and second sections 135 and 140. The first inorganic ARC section 135 operates in the absorption mode; the second inorganic ARC section 140 reduces the difference in the refractive indices of the first inorganic ARC section and the photoresist. Such a configuration reduces reflectivity in the resist, resulting in improved CD control.

In one embodiment, the first inorganic ARC section 135 is in contact with the substrate. Since the first inorganic ARC section operates in the absorption mode, the substrate characteristics do not influence its performance.

The first inorganic ARC section 135 absorbs substantially all light passing or reflected therein. In one embodiment, the first inorganic section comprises a k of at least about 0.2 and preferably at least about 0.5. The refractive index is dependent on the k. In one embodiment, the first inorganic ARC section comprises a k of about 0.56 and an n of about 2.1

The thickness of the first inorganic ARC section, for the given k, should be sufficient to absorb light passing through or reflected therein. The thickness, in one embodiment, is about 5-150 nm. Of course, the thickness may vary depending on the k value and the amount of light the second ARC section needs to absorb.

The second inorganic ARC section 140, which is above the first inorganic ARC section, serves to reduce the difference in the refractive indices between two layers, the resist and first inorganic ARC section. Illustratively, the difference between the refractive indices of the first inorganic ARC section 135 and the resist is about 0.36 (e.g., 2.1 minus 1.74). The second inorganic ARC section reduces the magnitude of this difference (0.36) in order to reduce the reflectivity in the resist. To reduce the difference between the refractive indices of two layers, the n of the second inorganic ARC section140 is selected to have a value between the refractive indices of the two layers.

In one embodiment, the second inorganic ARC section 140 comprises a graded refractive index. The graded refractive index reduces the difference between the refractive indices of the first inorganic ARC section 135 and resist 170. In one embodiment, the graded refractive index, from the bottom to the top of the second inorganic ARC section, decreases from a value equal to about the first inorganic ARC section to a value equal to about the resist.

Fig. 2a shows a refractive index profile of the second inorganic ARC section 140. Illustratively, the first ARC section comprises an n value of about 2.1 and the resist layer comprises an n value of about 1.74. These values are typical for a first inorganic ARC section operating in the absorption mode and a conventional resist. Of course, the first inorganic ARC section 135 and resist 170 may comprise other n values.

At the interface of the first and second inorganic ARC 140 sections, the second inorganic ARC comprises an n value equal to about the first inorganic ARC section 135. The n value in the second inorganic ARC 140 section decreases as you move up through the second inorganic ARC section 140 toward the resist layer 170. The n of the second inorganic ARC section 140 decreases to a value equal to about the n of the resist 170 at the interface of the second inorganic ARC section 140 and the resist 170.

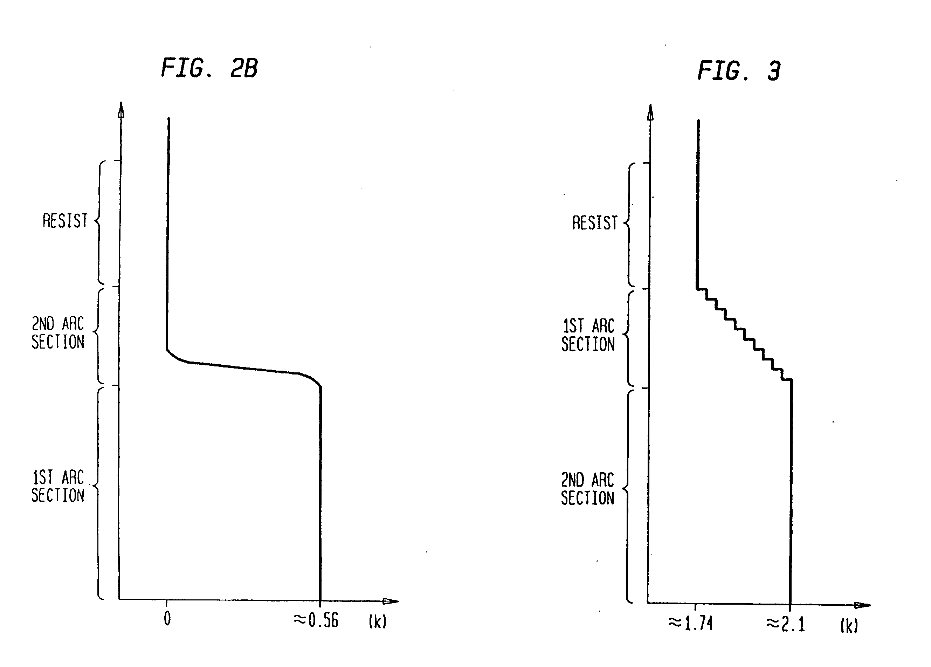

The extinction coefficient is somewhat dependent on n. As n is decreased, k also decreases. Fig. 2b plots the relationship of the k in the second inorganic ARC section 140 with respect to the n corresponding to the plot in Fig. 2a. As shown, k decreases much more rapidly as the composition of the film is changed to decrease n.

The graded refractive index of the second inorganic ARC section 140 is shown in Fig. 2a as a smooth transition. A second inorganic ARC section 140 comprising a graded refractive index having step transitions is also useful, as shown in Fig. 3.

Illustratively, as shown in Fig. 2a, the n value in the lower portion of the second inorganic ARC section 140 starts at a value equal to about the first inorganic ARC section and decreases to equal to about the n of the resist in the upper portion. The values of n can be varied in the respective portions of the second inorganic ARC section 140. For example, n can be greater or less than the n value of first inorganic ARC section 135 or the resist 170 in the lower and upper portions, respectively, of the second inorganic ARC section 140. Furthermore, the grade of the refractive index can be varied depending on different parameters, such as thickness or the magnitude of the difference between the refractive indices of the first inorganic ARC section 135 and resist 170. Reduction in reflectivity of the resist is achieved if the difference between the n values of the first inorganic ARC section and resist 170 is reduced.

Reflectance occurs when you have two layers with different refractive indices. If the bottom layer operates in the absorption mode, than it can be assumed that the interface at the bottom of the lower layer does not contribute to the reflectivity in the upper layer. As such, the reflectivity in the upper layer is defined as follows:

$$R = Iref/Iin = [(n1-n2)/(n1+n2)]$$

where

R =    reflectivity,

Iref = intensity of reflected light,
Iin = intensity of incidence light,
n1 = refractive index of the lower layer,
n2 = refractive index of the upper layer.

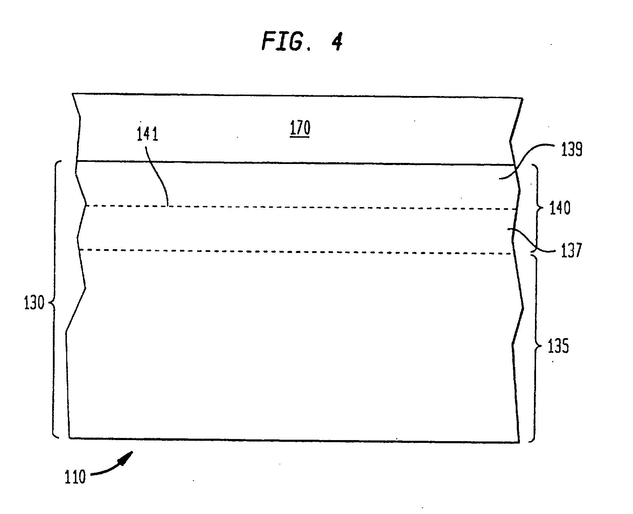

Referring to Fig. 4, one embodiment of the invention is shown. Fig. 4 depicts a second inorganic ARC section 140 comprising a graded refractive index that provides an additional interface 141 between the first inorganic ARC section 135 and resist 170. The reflectivity in the resist with the first inorganic ARC section 135 operating in the absorption mode can be expressed as:

$$RR = R2 + R1$$

$$= [(n2-nR)/(n2+nR)] + [(n1-n2)/(n1+n2)]$$

where

RR = the reflectivity into the resist 170,
R2 = the reflectivity into the upper part 139 of the second inorganic ARC section,
R1 = the reflectivity into the lower part 137 of the second inorganic ARC section,
nR = refractive index of the resist layer 170,
n2 = refractive index of the upper part 139 of the second inorganic ARC section, and
n1 = refractive index of the lower part 137 of the second inorganic ARC section.

Due to the non-linear relationship (i.e., quadratic) between the reflectivity and the refractive indices, reducing the difference between the refractive indices between adjacent layers as provided by one additional interface leads to an overall reduction in the reflectivity into the top layer.

In another embodiment of the invention, the second inorganic ARC section 140 comprises a graded refractive index that is a step function. Such a graded refractive index can be viewed as producing a plurality of sub-sections within the second inorganic ARC section 140, each with a different n value selected so as to reduce the difference in the n values between adjacent sub-sections. The reflectivity of the resist layer 170 having a second inorganic ARC section 140 with x number of subsections and a first inorganic ARC section 135 operating in the absorption mode can be generalized as follows:

$$RR = R1 + R2 ... + Rx$$

where

RR = the reflectivity in the resist,
R1 = the reflectivity in the sub-section of the second inorganic ARC section beneath the resist,
R2 = the reflectivity in the sub-section of the second inorganic ARC section below R1, and
Rn = the reflectivity in the sub-section of the second inorganic ARC section contacting the first inorganic ARC section.

By having a series of interfaces, the difference in the refractive indices between adjacent sub-sections is decreased, thereby decreasing the reflectivity in the resist. Increasing the number of sub-sections in the second inorganic ARC section 140 generally further decreases the difference between the n values of adjacent sub-sections, resulting in a greater reduction in the overall reflectivity back into the resist 170. As the difference in the n values between adjacent sub-sections approaches zero or is infinitesimally small, as in the case where the graded refractive index is continuous and smooth, the overall reflectivity in the top layer or resist 170 approaches zero.

As described, the second inorganic ARC section 140 can be formed with a graded n having different grades or different number of layers to produce the desired reduction in the difference between the refractive indices of the first inorganic ARC section and resist. The number of layers or the specific graded n can be chosen to meet specific needs or optimized for specific processes. Furthermore, there is no restriction in the thickness of the overall second inorganic ARC section or the sub-sections therein. However, for practical reasons, the second inorganic ARC section 140 should be relatively thin to reduce resist consumption and cost. Also, the change in the refractive indices of adjacent subsections does not have to be the same. Additionally, the first and second inorganic ARC section 135, 140 need not comprises the same type of inorganic ARC. Different inorganic ARCs can be used to form the first and second inorganic ARC sections 135, 140 to achieve a reduction in the refractive indices between the first inorganic ARC section 135, 140 and resist 170. Also, substituting the first inorganic ARC section 135 with an organic ARC can also be useful.

The deposition of the second inorganic ARC section 140 to produce a graded refractive index can be achieved by tuning the inorganic ARC to have the desired n profile. For example, after deposition of the first inorganic ARC section is completed, the precursor gas flows can be continuously varied during CVD deposition of the second inorganic ARC section 140 to appropriately modify the n. The gas flows can be controlled, for example, to form smooth or stepped transitions in the n profile. Other techniques that modify the refractive index of the second inorganic ARC 140 section can also be used.

Resist poisoning may occur in some instances, particularly with inorganic ARCS that comprise nitrogen. The nitrogen appears to interact with the resist, undesirably affecting the physical properties of the resist. In one embodiment, a nitrogen-free or reduced nitrogen inorganic ARC sub-section is provided in the upper portion of the second inorganic ARC section 140 to prevent resist poisoning. For example, in the case of silicon oxynitride, removal of the nitrogen produces a silicon-rich oxide which does not interact with the resist. The thickness of the reduced nitrogen or nitrogen-free sub-section should be thin while still capable of preventing resist poisoning. The thickness is, for example, 1 nm or less.

In some applications, the inorganic ARC comprises hard mask qualities. Such qualities are particularly useful in, for example, dual-damascene applications. To provide hard mask qualities, the top portion of the second inorganic ARC section 140 comprises an inorganic ARC hard mask sub-section. The thickness of the hard mask sub-section should be relatively thin, for example, about 1 nm or less.

In one embodiment, the inorganic ARC hard mask sub-section comprises a silicon-rich material. The hard mask sub-section can be formed from, for example, a silicon-based DARC. Such silicon-based DARC includes, for example, silicon nitride, silicon oxynitride, or other type of DARC comprising silicon. In one embodiment, the hard mask portion comprises silicon oxynitride which has its nitrogen component reduced or removed during the deposition process. The silicon-rich material can advantageously serve as both a hard mask and to reduce or avoid resist poisoning.

## Claims

1. In lithography, a method for reducing reflectivity in a resist comprising:

   depositing an antireflective, inorganic coating (ARC) over a substrate (110); and
   depositing a resist layer (170) over the ARC,

   wherein the ARC comprises a first section (135) and second section (140); the first section (135) operates in absorption mode and the second section (140) comprises a refractive index that reduces a difference between refractive indices of the first section (135) and the resist layer (170), **characterized in that**
   the second ARC section (140) comprises a graded refractive index, wherein graded refractive index at a lower surface of the first ARC section (135) is equal to about the refractive index of the first ARC section (135) and the graded refractive index at an upper surface of the second ARC section (140) is equal to about the resist (170).

2. The method as recited in claim 1 wherein the first ARC section (135) is deposited over the substrate (110) and the second ARC section (140) is deposited over the first ARC section (135).

3. The method as recited in claim 2 wherein the first ARC section (135) comprises an extinction coefficient of at least 0.2.

4. The method as recited in claim 1 wherein the second ARC section comprises refractive index between the refractive indices of the first ARC section and resist.

## Patentansprüche

1. Verfahren in der Lithographie zum Reduzieren des Reflexionsgrades eines Resist:

   Abscheiden einer anorganischen Antireflexbeschichtung (ARC) über einem Substrat (110) und
   Abscheiden einer Resistschicht (170) über der ARC,

   wobei die ARC einen ersten Abschnitt (135) und einen zweiten Abschnitt (140) umfaßt; wobei der erste Abschnitt (135) im Absorptionsmodus arbeitet und der zweite Abschnitt (140) einen Brechungsindex aufweist, der eine Differenz zwischen Brechungsindizes des ersten Abschnitts (135) und der Resistschicht (170) reduziert, **dadurch gekennzeichnet, daß**

   der zweite ARC-Abschnitt (140) einen abgestuften Brechungsindex aufweist, wobei der abgestufte Brechungsindex an einer unteren Oberfläche des ersten ARC-Abschnitts (135) etwa gleich dem Brechungsindex des ersten ARC-Abschnitts (135) und der abgestufte Brechungsindex an einer oberen Oberfläche des zweiten ARC-Abschnitts (140) etwa gleich dem des Resist (170) ist.

2. Verfahren nach Anspruch 1, wobei der erste ARC-Abschnitt (135) über dem Substrat (110) und der zweite ARC-Abschnitt (140) über dem ersten ARC-Abschnitt (135) abgeschieden wird.

3. Verfahren nach Anspruch 2, wobei der erste ARC-Abschnitt (135) einen Extinktionskoeffizienten von mindestens 0,2 aufweist.

4. Verfahren nach Anspruch 1, wobei der zweite ARC-Abschnitt einen Brechungsindex zwischen den Brechungsindizes des ersten ARC-Abschnitts und des Resist aufweist.

## Revendications

1. °) Procédé utilisé en lithographie pour réduire le pouvoir réfléchissant dans un photorésist ou résist, comprenant :

le dépôt d'une couche anti-réfléchissante (CAR) inorganique sur un substrat (110); et le dépôt d'une couche de résist (170) sur la CAR,

dans lequel la CAR comprend une première section (135) et une seconde section (140) ; la première section (135) fonctionnant en mode d'absorption et la seconde section (140) présentant un indice de réfraction qui réduit la différence entre les indices de réfraction de la première section ( 135) et de la couche de résist (170),
**caractérisé en ce que**
la seconde section de CAR (140) présente un indice de réfraction progressif dans lequel l'indice de réfraction progressif à l'endroit de la surface inférieure de la première section de CAR (135) est à peu près égal à l'indice de réfraction de cette première section de CAR (135), tandis que l'indice de réfraction progressif à l'endroit de la surface supérieure de la seconde section de CAR (140) est à peu près égal à celui du résist (170).

2. Procédé selon la revendication 1,
dans lequel
la première section de CAR (135) est déposée sur le substrat (110) et la seconde section de CAR (140) est déposée sur la première section de CAR (135).

3. Procédé selon la revendication 2, la première section de CAR (135) présente un coefficient d'extinction d'au moins 0,2.

4. Procédé selon la revendication 1,
dans lequel
la seconde section de CAR présente un indice de réfraction comprise entre les indices de réfraction de la première section de CAR et du résist.

## FIG. 1

## FIG. 2A

# FIG. 2B

RESIST

2ND ARC
SECTION

1ST ARC
SECTION

0          ≈0.56    (k)

# FIG. 3

RESIST

1ST ARC
SECTION

2ND ARC
SECTION

≈1.74      ≈2.1     (k)

EP 1 039 347 B1

9

FIG. 4